Europäisches Patentamt

**European Patent Office**

Office européen des brevets

(11) Veröffentlichungsnummer: **0 222 982**
**B1**

(12) **EUROPÄISCHE PATENTSCHRIFT**

(45) Veröffentlichungstag der Patentschrift:
31.10.90

(51) Int. Cl.⁵: **G01R 33/34**

(21) Anmeldenummer: 86111082.3

(22) Anmeldetag: 11.08.86

(54) Oberflächenspule für die Untersuchung mit Hilfe der kernmagnetischen Resonanz.

(30) Priorität: 18.11.85 DE 3540872

(43) Veröffentlichungstag der Anmeldung:
27.05.87 Patentblatt 87/22

(45) Bekanntmachung des Hinweises auf die Patenterteilung:
31.10.90 Patentblatt 90/44

(84) Benannte Vertragsstaaten:
DE FR GB NL

(56) Entgegenhaltungen:
EP-A- 0 047 065
EP-A- 0 160 942
EP-A- 0 170 558
WO-A-84/00214
DE-A- 3 140 319
DE-C- 912 583
FR-A- 2 530 816
US-A- 2 615 134

PATENTS ABSTRACTS OF JAPAN, Band 5,
Nr. 78 (E-58)[750], 22. Mai 1981; &
JP-A-56 27 509 (PIONEER K.K.) 17-03-1981
"Electromagnetic Field Probes" Technical Report
No. 377 (1962), Cruft Laboratory, Harvard University,
Cambridge, Massachusetts

(73) Patentinhaber: Siemens Aktiengesellschaft,
Wittelsbacherplatz 2, D-8000 München 2(DE)

(72) Erfinder: Zabel, Hans-Joachim, Freiburgerstrasse 43,
D-6900 Heidelberg(DE)
Erfinder: Bader, Reiner, Dr.,
Gerhart-Hauptmann-Strasse 18, D-6900 Heidelberg(DE)
Erfinder: Lorenz, Walter J., Prof. Dr. Dipl.-Phys.,
Kastellweg 26, D-6900 Heidelberg(DE)

## Beschreibung

Die Erfindung betrifft eine Oberflächenspule für spektroskopische oder bildgebende Untersuchungen eines Objektes mit Hilfe der kernmagnetischen Resonanz. Das Untersuchungsobjekt befindet sich dabei in einem homogenen magnetischen Grundfeld einer MR-Anlage. Die Oberflächenspule wird in der Nähe des zu untersuchenden Bereiches positioniert und kann mit Hilfe eines Hochfrequenzpulses über das magnetische Wechselfeld die Kernspins des Untersuchungsobjektes anregen. Danach wird das von den angeregten Kernspins ausgesandte Kernresonanzsignal von der Oberflächenspule aufgenommen und in der MR-Anlage abgespeichert.

Anwendungen von Oberflächenspulen in der Phosphorspektroskopie sind z.B. in den Artikeln "Journal of Magnetic Resonance" 60, Seiten 268 bis 279 (1984) und "Journal of Magnetic Resonance" 55, Seiten 164 bis 169 (1983) beschrieben worden. Eine Antenne geformt durch ein Koaxialleiterstück ist aus DE-C 912 583 und JP-A 5 627 509 bekannt.

Mit Oberflächenspulen für die Anregung und den Signalempfang wird durch die Beschränkung auf kleinere Untersuchungsbereiche eine höhere Bildqualität (Signal-Rausch-Verhältnis) und damit eine höhere Detailerkennbarkeit erreicht. Diese Spulen können dem jeweiligen Untersuchungsbereich geometrisch angepaßt werden.

Oberflächenspulen werden meistens im Zusammenwirken mit abstimmbaren Schwingkreisen benutzt. Ein Nachteil dieser Anordnung ist die Empfindlichkeit ihrer Abstimmung auf elektrische Störstrahlungen von außen oder auch die Bewegung des Untersuchungsobjektes, die zu Phasenfehlern führt. Ebenso nachteilig sind die aufwendige Herstellung der elektrischen Anpaßeinheit, die Unflexibilität in der Anwendung des komplexen Systems, die Unhandlichkeit für die Anwendung am menschlichen Körper sowie die daraus und aus dem Abstimmvorgang resultierende lange Meßvorbereitungszeit.

Der Erfindung liegt die Aufgabe zugrunde, eine einfach aufgebaute, handliche Oberflächenspule zu schaffen, welche leicht anpaßbar und störstrahlungssicher ist.

Die Aufgabe wird erfindungsgemäß durch die Merkmale des Anspruchs 1 gelöst.

Diese Anordnung wirkt als eine Rahmenantenne, die zur Vermeidung von Störungen mit einer an bevorzugter Stelle unterbrochenen koaxialen Abschirmung versehen ist. Das Koaxialleiterstück kann, wenn es flexibel ausgeführt wird, zu einer beliebig geformten Schleife gebogen werden. An einem Ende des Koaxialleiterstückes werden sowohl der Innenleiter als auch die Mantelabschirmung mit der Mantelabschirmung des anderen Endes des Koaxialleiterstückes elektrisch leitend verbunden. Dort ist auch der elektrische Einspeisungspunkt über ein koaxiales Einspeisungskabel vorgesehen. Die Schlitzbreite der Unterbrechung der Mantelabschirmung sollte etwa dem Abstand des Innenleiters zur Mantelabschirmung entsprechen. Die Anpassung der Rahmenantenne an den Eingang des Meßverstärkers geschieht durch λ/2 Transformation über die koaxiale Einspeisungsleitung. In einer bevorzugten Ausführungsform kann das schleifenförmige Koaxialleiterstück durch das Endstück einer koaxialen Einspeisungsleitung gebildet werden. Die Anpassung kann in diesem Fall z.B. dadurch erreicht werden, daß die Gesamtlänge der Leitung mit n • λ/2 gewählt wird. Diese einfache Art der Antennenausführung und der Antennenankopplung ist sehr handlich bei der Anwendung am Patienten und vermeidet die approximative, kapazitive Abstimmung. Eine verbesserte Bildqualität und räumliche Auflösung wird insbesondere im Frequenzbereich von Hochfeld-Kernspintomographen (größer 1 Tesla) erreicht und bleibt durch die Faradaysche Wirkung der Mantelabschirmung auch bei ungenügender Raumabschirmung von äußeren elektrischen Störstrahlungen unbeeinflußt.

Vorteilhafte Ausgestaltungen der Erfindung sind in den Unteransprüchen angegeben.

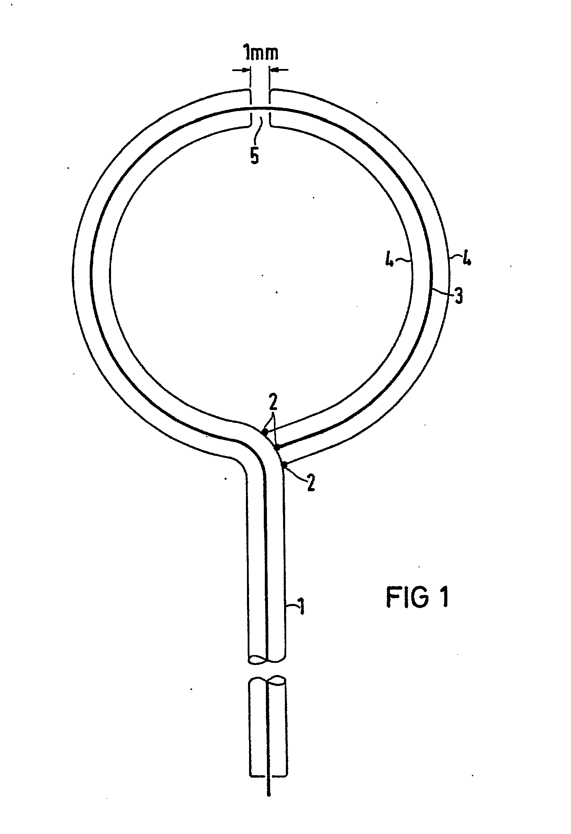

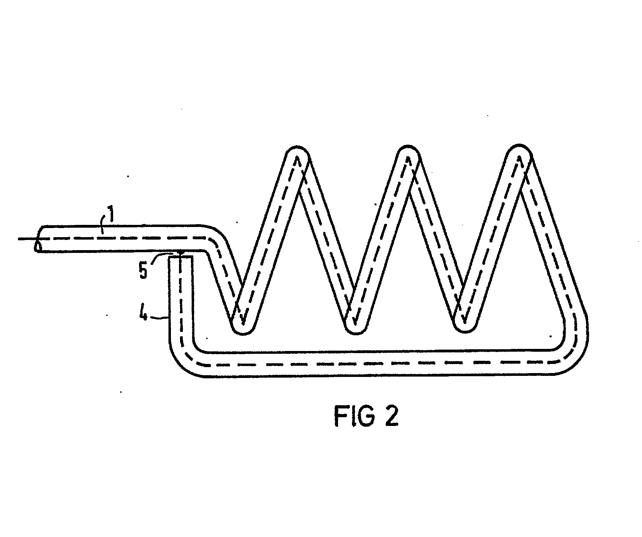

Die Erfindung ist nachfolgend anhand von Ausführungsbeispielen nach den Figuren 1 und 2 näher erläutert.

Die Figur 1 zeigt ein erstes Ausführungsbeispiel der erfindungsgemäßen Rahmenantenne. Das Endstück einer koaxialen Einspeisungsleitung 1 mit der Gesamtlänge n • λ/2 ist zu einer kreisförmigen Schlaufe gebogen und am Ende 2 dieser Leitung sind sowohl der Innenleiter 3 als auch die Mantelabschirmung 4 mit der Mantelabschirmung am Anfangspunkt 2 der Schleife elektrisch verbunden. An einem dem Anfangspunkt 2 der Schleife gegenüberliegenden Punkt 5 weist die Abschirmung 4 eine Unterbrechung auf (ca. 1 mm).

Fig. 2 zeigt ein weiteres Ausführungsbeispiel der Erfindung.

Dabei ist das die Oberflächenspule bildende Koaxialleiterstück als Solenoid mit mehreren Windungen ausgeführt, wobei an dem dem Anfangspunkt des Solenoids gegenüberliegenden Ende das Koaxialleiterstück wieder zum Anfangspunkt zurückgeführt wird. Die Unterbrechung 5 der Mantelabschirmung 4 ist in diesem Falle am Anfangspunkt an der Verbindungsstelle mit der Einspeiseleitung 1 vorgesehen. Die Windungen des Solenoids können auch unterschiedliche Durchmesser haben. Die dargestellte Anordnung hat den Vorteil, daß die Hochfrequenz-Einspeisung und die Signalerfassung aufgrund der verbesserten Homogenität über einen größeren Volumenbereich möglich wird.

Die geringe Anfälligkeit gegen kapazitive Verstimmung der als Koaxialleiter aufgebauten Oberflächenspule ermöglicht es, auch komplexere Antennensysteme mit mehreren Oberflächenspulen ohne Probleme mit der gegenseitigen Verstimmung vorzusehen. Damit wird eine flexible Anpassung an das Untersuchungsobjekt mit einer Erhöhung des Füllfaktors möglich.

## Patentansprüche

1. Oberflächenspule für die spektroskopische oder bildgebende Untersuchung eines Objektes mit Hilfe der kernmagnetischen Resonanz gebildet, durch ein zu einer schleife geformtes Koaxialleiterstück, dessen Mantelabschirmung (4) symmetrisch bezüglich des Anfangspunktes (2) der Schleife eine Unterbrechung aufweist, wobei an einem Ende (2) des Koaxialleiterstückes sowohl der Innenleiter (3) als auch die Mantelabschirmung (4) mit der Mantelabschirmung des anderen Endes des Koaxialleiterstückes elektrisch verbunden sind und wobei die Oberflächenspule mit Hilfe einer λ/2 Transformation über die Einspeiseleitung (1) angepaßt ist.

2. Oberflächenspule nach Anspruch 1, dadurch gekennzeichnet, daß das schleifenförmige Koaxialleiterstück flexibel ist und entsprechend den räumlichen Erfordernissen bei der Untersuchung des Objektes gebogen werden kann.

3. Oberflächenspule nach Anspruch 1 oder 2, dadurch gekennzeichnet, daß das Koaxialleiterstück als Solenoid mit mehreren Windungen ausgeführt ist.

## Claims

1. Surface coil for the spectroscopic or image-forming analysis of an object with the aid of nuclear magnetic resonance, formed by a coaxial conductor piece moulded to make a loop, the screening sheath (4) of which has a break symmetrically with respect to the starting point (2) of the loop, and at one end (2) of the coaxial conductor piece both the inner conductor (3) and the screening sheath (4) are electrically connected to the screening sheath of the other end of the coaxial conductor piece, and the surface coil is matched to the feed line (1) with the aid of a λ/2 transformation.

2. Surface coil according to claim 1, characterised in that the loop-like coaxial conductor piece is flexible and can be curved in accordance with the spatial requirements during analysis of the object.

3. Surface coil according to claim 1 or 2, characterised in that the coaxial conductor piece is constructed as a solenoid with several turns.

## Revendications

1. Bobine de surface pour l'examen spectroscopique d'un objet ou pour l'examen avec reproduction de l'image d'un objet à l'aide de la résonance magnétique nucléaire, formée par un élément de conducteur coaxial réalisé avec la forme d'une boucle et dont la gaine de blindage (4) est interrompue dans une position symétrique par rapport au point de départ (2) de la boucle, et dans laquelle à une extrémité (2) de l'élément de conducteur coaxial, aussi bien le conducteur intérieur (3) que la gaine de blindage (4) sont reliés électriquement à la gaine de blindage de l'autre extrémité de l'élément de conducteur coaxial, la bobine de surface étant adaptée au moyen d'une transformation λ/2 par l'intermédiaire de la ligne d'alimentation (1).

2. Bobine de surface suivant la revendication 1, caractérisée par le fait que l'élément de conducteur coaxial en forme de boucle est flexible et peut être recourbé conformément aux exigences spatiales lors de l'examen de l'objet.

3. Bobine de surface suivant la revendication 1 ou 2, caractérisé par le fait que l'élément de conducteur coaxial est réalisé sous la forme d'un solénoïde comportant plusieurs spires.

1mm

5

4 4

3

2

2

1

FIG 1

FIG 2